Europäisches Patentamt

European Patent Office

Office européen des brevets

(19)

(11) Veröffentlichungsnummer: **0 043 028**
**B1**

(12) **EUROPÄISCHE PATENTSCHRIFT**

(45) Veröffentlichungstag der Patentschrift:
15.02.84

(21) Anmeldenummer: 81104629.1

(22) Anmeldetag: 16.06.81

(51) Int. Cl.³: **C 04 B 35/60**, C 04 B 35/64,
C 03 C 3/22, H 01 L 21/48,
H 01 L 23/14

(54) Verfahren zum Herstellen eines Keramiksubstrates mit einer glasierten Oberfläche.

(30) Priorität: 26.06.80 US 163034

(43) Veröffentlichungstag der Anmeldung:
06.01.82 Patentblatt 82/1

(45) Bekanntmachung des Hinweises auf die Patenterteilung:
15.02.84 Patentblatt 84/7

(84) Benannte Vertragsstaaten:
DE FR GB

(73) Patentinhaber: International Business Machines
Corporation, Old Orchard Road, Armonk, N.Y. 10504 (US)

(72) Erfinder: Gonzales, Frank, Jr., 6 Longview Road,
Poughkeepsie New York 12603 (US)
Erfinder: Sobon, Joseph, 68 Plattekill Avenue, New Paltz
New York 12561 (US)

(74) Vertreter: Neuland, Johannes, Dipl.-Ing., Schönaicher
Strasse 220, D-7030 Böblingen (DE)

(56) Entgegenhaltungen:
EP - A - 0 005 198
DE - A - 2 554 969
US - A - 3 486 872
US - A - 3 540 894
US - A - 3 956 052

IBM TECHNICAL DISCLOSURE BULLETIN, Band 22, Nr.
4, September 1979 R.N. MASTER et al. "Binder Systems
for Multilayer Glass-Ceramic Substrate"

## Verfahren zum Herstellen eines Keramiksubstrates mit einer glasierten Oberfläche

Die Erfindung bezieht sich auf ein Verfahren zum Herstellen eines Keramiksubstrates mit einer glasierten Oberfläche, das zur Aufnahme von Halbleiterschaltungen dient.

Aus der deutschen Offenlegungsschrift 2554969 ist es bekannt, keramische Sinterkörper mit Oberflächenveredlungen in Form von Glasuren nach den in der Keramikindustrie üblichen Verfahren zu versehen.

Die US-Patentschrift Nr. 3540894 vermittelt die technische Lehre, ein dichtes keramisches Material herzustellen, das aufgrund seiner niedrigen Brenntemperatur und geringen Schrumpfung besonders für die Verwendung als mehrlagiges keramisches Substrat für Halbleiterschaltungen geeignet ist.

Beim Formen von Keramiksubstraten für Halbleiterschaltungen ist es wichtig, dass die Oberfläche des Substrates relativ glatt ist, so dass eine oder mehrere Metallisierungslagen auf der Oberfläche abgeschieden werden können, um als Leitungsmuster für Ausgangsverzweigungen der Halbleiterbauelemente zu dienen, und auch zur Verbindung der Metallisierungslagen zwischen Halbleiterchips, die auf einem Substrat angeordnet sind.

Mit der wachsenden Dichte der monolithisch integrierten Halbleiterbauelemente ist auch die Struktur der Anordnungen, die die monolithisch integrierten Halbleiterbauelemente aufnehmen, ebenfalls dichter und komplexer geworden. Substrate, die eine Reihe von Halbleiterbauelementen aufnehmen und miteinander verbinden, sind allgemein bekannt. Die Substratstruktur, die in der Lage ist, mehrere monolithisch integrierte Halbleiterschaltungen miteinander zu verbinden, muss mit einem verhältnismässig dichten und komplexen Metallisierungssystem aus sehr feinen Leitungen versehen werden. Die Metallisierung kann im Inneren des Substrates angeordnet sein, wie bei dem mehrschichtigen keramischen Substrat, das in dem US-Patent Nr. 3838204 beschrieben ist oder auch in der Veröffentlichung im IBM Technical Disclosure Bulletin, Vol. 13, Nr. 4, September 1970, Seite 962. Alternativ kann das Metallisierungssystem verkörpert werden durch eine oder mehrere Lagen von Leiterzügen auf der Oberfläche des Substrates, wie das in dem US-Patent Nr. 3388301 beschrieben ist oder es kann verwirklicht sein durch eine Kombination von im Inneren des Substrates verlaufenden Leiterzügen und solchen, die an der Oberfläche verlaufen, wie das in dem US-Patent Nr. 3726002 beschrieben ist.

Wenn die Leiterzüge sich auf der oberen Fläche eines keramischen Substrates befinden, ist es ein übliches Verfahren zur Bildung feiner Leiterzüge, eine Metallschicht aufzudampfen, beispielsweise aus Aluminium, und anschliessend die unerwünschten Teile der Schicht durch photolithographisches Maskieren und subtraktive Ätzverfahren zu entfernen. Wenn mehr als eine Metallisierungslage erwünscht ist, wird eine Schicht aus einem dielektrischen Material, wie z.B. aus einem Polyimidharz, auf die Metallisierungslage aufgebracht, Durchverbindungslöcher werden in die dielektrische Schicht geätzt und eine nachfolgende Metallschicht wird abgeschieden und subtraktiv geätzt.

Wenn die Leiterzüge schmaler werden, wird die Art der Oberfläche des keramischen Substrates, auf der die Leiterzüge gebildet werden, kritischer. Wenn die Oberfläche zu rauh ist, kann das Ätzmittel unter einem maskierten Bereich unter die Metallschicht gelangen und Teile oder sogar den gesamten Metallisierungsstreifen entfernen. Die Maskierungsschicht auf der oberen Fläche der Metallisierungsschicht verhindert diese Ätzwirkung nicht. Daher können die Metallisierungsstreifen in einem solchen Ausmass eingeschnürt werden, dass sie später ausfallen oder im Extremfall aufgetrennt werden, bevor die Packungsanordnung vervollständigt ist.

Ein Verfahren zum Erzeugen einer glatten Oberfläche auf einem keramischen Substrat besteht darin, die Oberfläche zu polieren. Jedoch ist das Polieren eines gesinterten keramischen Substrates zeitaufwendig und teuer, da das Material sehr hart ist. Ein anderes Verfahren besteht darin, eine dünne Glasschicht auf der Oberfläche des keramischen Substrates abzuscheiden, wie das in dem US-Patent Nr. 3437505 beschrieben ist. Dieses Verfahren hat jedoch für das Packen monolithisch integrierter Halbleiterschaltungen seine Beschränkungen. Wenn das Substrat Löcher aufweist zur Aufnahme von Stiften, erzeugt die Oberflächenspannung des Glases um die Löcher herum eine abgerundete und dünner werdende Glasschicht. Dies ist jedoch ganz unannehmbar.

Hier will die Erfindung Abhilfe schaffen. Die Erfindung, wie sie in den Ansprüchen gekennzeichnet ist, löst die Aufgabe, ein Verfahren zum Herstellen eines Keramiksubstrates mit einer glasierten Oberfläche anzugeben, das die vorher geschilderten Nachteile bekannter Verfahren nicht aufweist.

Im folgenden wird die Erfindung näher erläutert.

Zur Ausübung der Erfindung wird ein geeignetes keramisches Material ausgewählt, das die Anforderungen für die Anwendung beim Packen monolithisch integrierter Halbleiterschaltungen erfüllt. Verschiedene physikalische und chemische Eigenschaften müssen in Betracht gezogen werden, wie z.B. die Dielektrizitätskonstante des Materials, der spezifische Widerstand, der Ausdehnungskoeffizient usw. Im allgemeinen muss der Erweichungspunkt des ausgewählten keramischen Materials oberhalb des Erweichungspunktes des Glases liegen, das die zweite Komponente der ungebrannten keramischen Mischung bildet, was noch im einzelnen beschrieben wird. Das ausgewählte keramische Material darf bei oder unterhalb der Sintertemperatur nicht mit dem Glasmaterial reagieren. Im allgemeinen sollte das keramische Material nicht unterhalb von 1200° C zu seiner endgültigen Dichte sintern. Typische keramische Materialien, die für die Ausübung des Verfahrens nach der Erfindung nützlich sind, enthalten Al₂O₃, BeO und MgO sowie Kombinationen davon, die noch andere unbedeutende Bestandteile einschliessen, die nicht aufgeführt sind. Die Teilchengrösse des keramischen Materials liegt in dem Bereich von 0,2 bis 35 µm Durchmesser, insbesondere in dem Bereich von 0,8 bis 16 µm. Wenn die durchschnittliche Teilchengrösse des keramischen Materials zu gross ist, sintert es nicht gut. Wenn die Teilchengrösse des keramischen Materials kleiner ist, fliesst das geschmolzene Glas nicht leicht durch das keramische Gefüge.

Ein besonderes Glasmaterial wird mit dem vorher beschriebenen keramischen Material kombiniert. Das Glas sollte einen Erweichungspunkt im Bereich von 500 bis 1100° C, insbesondere in dem Bereich von 950 bis 1010° C aufweisen, der noch genügend unterhalb der Sintertemperatur des keramischen Materials liegt. Das zur Ausübung der Erfindung verwendete Glas sollte nicht nennenswert mit der Hauptphase des keramischen Materials reagieren oder einen Kristall bilden. Die Wahl des Glasmaterials ist daher abhängig von der Wahl des keramischen Materials. Typische Glasmaterialien, die für die Verwendung bei der Ausübung der Erfindung geeignet sind, sind Mischungen aus CaO, MgO, SiO₂ und Al₂O₃. Die Menge des Glasmaterials in der ungebrannten keramischen Mischung ist grösser als die Hohlräume in dem gebrannten keramischen Material. Die richtige Menge des Glasmaterials in dem ungebrannten keramischen Material kann durch Versuche bestimmt werden. Eine allgemeine Richtlinie für die Menge des Glasmaterials, die beim Ausüben der Erfindung erforderlich ist, besteht darin, ein Gewichtsverhältnis im Bereich von 17 bis 35% des keramischen Materials einzuhalten, wenn die Teilchengrösse des keramischen Materials und des Glasmaterials gleich sind. Ein Überschuss an Glasmaterial über die Hohlräume des gesinterten keramischen Materials ist notwendig, um eine fehlerfreie glasige Oberfläche nach dem Sintern sicherzustellen.

Die Mischung aus den keramischen Teilchen und den Glasteilchen kann weiter mit einem Harzbindemittel und einem Lösungsmittel für das Bindemittel kombiniert werden und die erhaltene ungebrannte keramische Mischung gegossen oder in anderer Weise in die gewünschte Form für das Substrat gebracht werden. Typische Harzbindemittel, die für die Ausübung des Verfahrens nach der Erfindung geeignet sind, enthalten Polyvinylbutyral, Polyvinylalkohol, Polymethacrylate usw. Das Substrat kann in irgendeiner geeigneten Weise geformt werden, beispielsweise kann das Glasmaterial und das keramische Material in einer Form in die gewünschte Gestalt gepresst werden oder alternativ kann eine schlammartige Mischung, die das Bindemittel, das Lösungsmittel und einen Weichmacher enthält, zu ungebrannten Blättern geformt werden, die Blätter können bedruckt, gestanzt und zu einer laminierten Struktur zusammengesetzt werden, wie das in dem US-Patent Nr. 3540894 beschrieben ist.

Das geformte keramische Substrat wird dann auf ein geeignetes Formstück gelegt und gesintert. Das Formstück besteht aus einem Material, das durch das Glas nicht benetzbar ist, wie z. B. Molybdän, Wolfram, Tantal und Legierungen davon. Die Oberfläche des Formstückes besitzt die Form oder Textur der gewünschten glasierten Oberfläche des fertiggestellten Glassubstrates. Das Sintern erfolgt vorzugsweise in einer reaktionslosen Atmosphäre, wie H₂, N₂ oder Luft, der vorzugsweise Wasserdampf zugefügt wird. Das Sintern erfolgt bei einer Temperatur, die geeignet ist, das keramische Material zu seiner endgültigen Dichte zu sintern und die genügend oberhalb des Erweichungspunktes des vorher beschriebenen Glasmaterials in der Mischung liegt. Während des Sinterns verbrennt das Bindemittel, wenn es vorgesehen war und anschliessend erweichen die Glasteilchen, um eine Flüssigkeit zu bilden. Die glasartige Flüssigkeit setzt sich unter dem Einfluss der Schwerkraft auf der Bodenseite des Substrates ab und bildet in Berührung mit dem Formstück eine glatte oder sonstwie strukturierte glasartige Fläche auf der dem Formstück zugewandten Seite des Substrates. Durch das Setzen des Substrates auf das Formstück wird die untere Fläche in Kontakt mit dem Formstück gebracht. Wenn die richtige Menge an Glasmaterial vorgesehen wird, füllt das Glas im wesentlichen die Zwischenräume zwischen dem Keramikteilchen in dem ganzen Substrat aus und bildet dadurch einen undurchlässigen Körper. Während des Sinterns schrumpft das keramische Material üblicherweise beträchtlich. Daher müssen die vom Mittelpunkt des Substrates entfernten Teile sich nach innen bewegen, um sich der Schrumpfbewegung anzupassen. Das geschmolzene Glas an der Trennfläche zwischen dem Formstück und dem Substrat sorgt für einen Schmiereffekt und hilft dadurch, sicherzustellen, dass die Sinterschrumpfung durch das ganze Substrat hindurch gleichförmig ist. Die glasierte Fläche des Substrates nimmt die Konfiguration des Formstükkes an. Wenn eine sehr glatte Oberfläche gewünscht wird, ist das Formstück sehr glatt und poliert. Eine glatte polierte Oberfläche auf einem keramischen Substrat liefert eine sehr gute Basis zur Herstellung eines Leiterzugmusters auf der Oberfläche, das dort als Metallisierung für die Zwischenverbindungen dient.

Das Verfahren nach der Erfindung liefert auch ein Verfahren zur Bildung eines Metallisierungsmusters auf dem Substrat ohne Maskierung oder subtraktives Ätzen. Ein Metallisierungssystem kann auf dem Substrat angebracht werden, wenn seine obere Fläche so ausgebildet werden kann, dass die Leiterzüge in Vertiefungen verlaufen, d.h. in die Oberfläche des keramischen Substrates gedrückt werden. Daher kann ein leitendes Metall bequem und einfach dadurch abgeschieden werden, dass die Oberfläche des Substrates mit einer geeigneten leitenden Paste bestrichen wird, die nur in den Vertiefungen festgehalten wird. Dieses Verfahren zum Erzeugen eines vorgegebenen Musters aus einem leitenden Material auf einem Substrat ist in dem US-Patent Nr. 3956052 beschrieben. Bei dem Verfahren gemäss der vorliegenden Erfindung wird ein keramisches Substrat, das eine glasartige Schicht aufweist, gebildet, wie das vorher beschrieben wurde. Anschliessend wird das gesinterte Substrat auf ein zweites Formstück gelegt, das das gewünschte Leiterzugsmuster erhaben trägt, d.h., als erhabenes Relief auf der Fläche des Formstückes. Nachdem das Substrat sorgfältig ausgerichtet wurde, so dass das Muster auf dem Formstück dem gewünschten Anbringen der Leiterzüge auf dem Substrat entspricht, wird der Aufbau wieder erwärmt, auf eine Temperatur oberhalb des Schmelzpunktes des Glases. Zu diesem Zeitpunkt werden die erhabenen Leitungen auf dem Formstück in die glasartige Schicht auf dem Substrat hineingedrückt. Nach dem Abkühlen des Substrates kann seine Oberfläche mit einer geeigneten leitenden Paste bestrichen werden, die in den Vertiefungen abgeschieden und festgehalten wird, die während des zweiten Heizschrittes gebildet wurden.

Die folgenden Beispiele sind bevorzugte Ausführungsbeispiele des Verfahrens gemäss der Erfindung.

*Beispiel 1:*

Vier fein gemahlene Keramik-Glasmischungen wurden hergestellt, von denen jede 2000 g wog. Die Mischungen hatten die folgenden Zusammensetzungen:

| $Al_2O_3$ | Mullit | Fritte ($CuO/MgO/Al_2O_3/SiO_2$) |
|-----------|--------|-------------------------------------|
| 68.3 | 20.7 | 10 Gew. % |
| 64.5 | 20.5 | 15 Gew. % |
| 63 | 20 | 17 Gew. % |
| 60.7 | 20.5 | 20 Gew. % |

Die Fritte hat einen Erweichungspunkt von 980 ± 30° C. Ein System aus Lösungs- und Bindemittel wurde hergestellt, das bestand aus:

| Polyvinylbutyral (PVB) (1. Zugabe) | 34.0 g |
| Lösungsmittel für Polyvinylbutyral | 925.0 g |
| Weichmacher | 38.3 g |
| Polyvinylbutyral (2. Zugabe) | 102.0 g |

Jede Pulvermischung wurde zusammen mit der 1. Zugabe für das Polyvinylbutyral, das Lösungsmittel und den Weichmacher in eine Kugelmühle mit einem Fassungsvermögen von 6,8 l gegeben, die ungefähr zur Hälfte mit Aluminiumoxidkugeln gefüllt war und während acht Stunden gemahlen. Dann wurde der zweite Zusatz von Polyvinylharz zugegeben und die Mischung für weitere vier Stunden gemahlen. Der erhaltene Brei wurde aus der Mühle entfernt, entlüftet und mit einem Abstreifmesser zu einem keramischen Band geformt. Das Band wurde dann in Quadrate geschnitten und laminiert, um Substrate zu bilden aus 10 bis zu 30 Blättern. Die Substrate aus jeder der Mischungen wurden auf verschiedene Formstücke aus Molybdän gelegt, die verschiedene Oberflächenzustände aufwiesen, d.h. eine glatte Oberfläche und eine rauhe. Alle Substrate wurden in einen Sinterofen gebracht und einem Sinterzyklus ausgesetzt, in dem die Temperatur von der Raumtemperatur auf 1560° C mit einer Geschwindigkeit von 150° C/h erhöht wurde, die Temperatur für 3 h auf 1560° C gehalten und dann mit einer Geschwindigkeit von 100° C/h auf Raumtemperatur abgekühlt wurde.

Nach dem Abkühlen wurden die Substrate geprüft. Die aus den Mischungen 3 und 4 gebildeten Substrate wiesen eine zusammenhängende fehlerfreie glasierte Oberfläche auf, die die Eigenschaften des Formstückes, auf dem sie gesintert worden waren, angenommen hatte. Die auf den glatten Formstücken gesinterten Substrate hatten sehr glatte Oberflächen. Die auf rauhen Formstücken gesinterten Substrate wiesen glasierte Oberflächenüberzüge auf, die ungefähr die gleiche Oberflächenrauheit aufwiesen wie das Formstück. Die aus den Mischungen 1 und 2 gebildeten Substrate hatten keine glasierten Oberflächen und zeigten glanzlose, unwirksame Oberflächen, die für keramisches Material typisch sind. Das Beispiel zeigt, dass ein Mindestprozentsatz an Glas in der Mischung erforderlich ist, um eine glasierte Oberfläche zu erhalten. Dieser Betrag ändert sich mit dem keramischen Material, dem Glas und der Teilchengrösse. Es wurde vermutet, dass die Menge der Glasfritte so sein muss, dass das Volumen des Glases grösser ist als die Hohlräume in dem keramischen Material nach dem Sintern.

*Beispiel 2:*

Vier fein gemahlene Keramik-Glasmischungen wurden hergestellt, jede mit einem Gewicht von 2000 Gramm. Die Mischungen besassen die folgenden Zusammensetzungen:

| $Al_2O_3$ | Fritte ($CaO/MgO/Al_2O_3/SiO_2$) |
|-----------|-------------------------------------|
| 80 Gew. % | 20 Gew. % |
| 83 Gew. % | 17 Gew. % |
| 85 Gew. % | 15 Gew. % |
| 90 Gew. % | 10 Gew. % |

Das gleiche System aus Lösungs- und Bindemittel, das im Beispiel 1 beschrieben wurde, wurde mit der Keramik-Glasmischung kombiniert. Das gleiche Verfahren, das im Beispiel 1 beschrieben wurde, wurde beim Formen und Sintern angewandt.

Die aus den Mischungen 1 und 2 gebildeten Substrate wiesen eine zusammenhängende, fehlerfreie, glasierte Oberfläche auf, die die Eigenschaften des Formstückes annahmen, auf dem sie gesintert wurden, d.h. eine glatte Oberfläche bei einem glatten Formstück und eine rauhe Oberfläche bei einem rauhen Formstück. Die aus den Mischungen 3 und 4 gebildeten Substrate wiesen nichtreflektierende, matte Oberflächen auf, die typisch für gesinterte Keramik sind, ohne irgend eine Anzeige einer glasigen Oberfläche.

*Beispiel 3:*

Die aus den Mischungen 3 und 4 gesinterten Substrate des Beispiels 1, d.h. die Substrate mit einer glasigen Oberfläche, wurden auf Formstücke aus Molybdän gesetzt, auf denen Linien geätzt worden waren. Die Substrate wurden in einem Ofen erneut auf 1200° C erhitzt und eine Stunde lang bei dieser Temperatur gehalten. Die Temperatur überschritt den Erweichungspunkt des Glases. Nach dem Abkühlen wurden die Substrate untersucht und es wurde beobachtet, dass eingeprägte Linien in der glasierten Oberfläche entsprechend dem geätzten Linienmuster auf den Formstücken gbildet wurden. Dies ist ein Hinweis darauf, dass Linienmuster in der glasierten Oberfläche eines Substrates gebildet werden können, die mit elektrisch leitenden Materialien durch bekannte Verfahren gefüllt werden können, um ein Metallisierungssystem auf der Oberfläche eines Substrates für Halbleiterschaltungen zu bilden.

## Patentansprüche

1. Verfahren zum Herstellen eines Keramiksubstrates mit einer glasierten Oberfläche, aus einer Mischung aus Glas und Keramikmaterial, das bei der Sintertemperatur nicht mit Glas reagiert, gekennzeichnet durch folgende Verfahrensschritte:
a) Bilden einer innigen keramischen Mischung aus einem Keramikmaterial, dessen Teilchen einen durchschnittlichen Durchmesser im Bereich von 0,2 bis 35 µm aufweisen und einem Glasmaterial, das nicht mit dem keramischen Material reagiert, wenn es auf Temperaturen erhitzt wird, die ausreichen, um das keramische Material zu sintern, wobei das Glasmaterial einen Erweichungspunkt im Bereich von 500 bis 1000° C aufweist und in einer Menge vorhanden ist, dass das Volumen des geschmolzenen Glases grösser ist als die Hohlräume in dem keramischen Material nach dem Sintern,
b) Formgebung der keramischen Mischung,
c) Legen des erhaltenen ungebrannten keramischen Gegenstandes auf ein Formstück aus einem Material, das nicht durch das geschmolzene Glasmaterial benetzbar ist,
d) Erhitzen des Gegenstandes und des Formstückes in einer Umgebung, die nicht mit dem geschmolzenen glasartigen Material reagiert, um das Sintern des keramischen Materials und das Ausbilden einer glasierten Oberfläche mit einer der Konfiguration des Formstückes entsprechenden Struktur auf der dem Formstück zugewandten Seite des Substrats zu veranlassen.

2. Verfahren nach Anspruch 1, dadurch gekennzeichnet, dass das gesinterte Keramiksubstrat anschliessend auf ein Formstück gelegt wird, das mit einem erhabenen Spiegelbild der gewünschten Oberflächenkonfiguration des Metallisierungsmusters auf dem Keramiksubstrat versehen ist, dass das Keramiksubstrat und das Formstück auf eine Temperatur erhitzt werden, die genügend über dem Erweichungspunkt des glasartigen Materials liegt, wodurch ein eingeprägtes Linienmuster für die Metallisierung in dem glasartigen Material auf dem Keramiksubstrat gebildet wird, und dass dieses Muster mit einem elektrisch leitenden Material aufgefüllt wird.

3. Verfahren nach den Ansprüchen 1 und 2, dadurch gekennzeichnet, dass das besondere keramische Material aus einer Mischung von $Al_2O_3$ und Mullit besteht und das Glasmaterial in einer Menge vorhanden ist, die mindestens 17 Gew.% der Mischung beträgt.

4. Verfahren nach den Ansprüchen 1 und 2, dadurch gekennzeichnet, dass das besondere keramische Material im wesentlichen aus $Al_2O_3$ besteht und das Glasmaterial in einer Menge vorhanden ist, die mindestens 17 Gew.% der Mischung entspricht.

## Claims

1. Method of making a ceramic substrate with a glassy surface, consisting of a mixture of glass and ceramic material which at the sintering temperature does not react with glass, characterized by the following process steps:
a) forming an intimate ceramic mixture of a ceramic material whose particles have an average diameter in the range of 0.2 to 35 µm, and a glass material that does not react with the ceramic material if it is heated to temperatures sufficient to sinter the ceramic material, the glass material having a softening point in the range of 500 to 1000° C, and being present in such an amount that the volume of the molten glass exceeds the cavities in the ceramic material after sintering,
b) forming the ceramic mixture,
c) placing the resulting green ceramic object on a setter tile of a material that is not wettable by the molten glass material,
d) heating the object and the tile in an ambient non-reactive with the molten glassy material to cause the sintering of the ceramic material and the forming of a glassy surface with a structure corresponding to the configuration of the tile, on the substrate side facing the tile.

2. Method as claimed in claim 1, characterized in that the sintered ceramic substrate is subsequently placed on a setter tile having an embossed mirror image of the respective surface configuration of the metallization pattern on the ceramic substrate, that the ceramic substrate and the setter tile are heated to a temperature sufficiently above the softening point of the glassy material, thereby forming a resessed line pattern for the metallization in the glassy material on the ceramic substrate, and that this pattern is filled with an electrically conductive material.

3. Method as claimed in claims 1 and 2, characterized in that the particulate ceramic material consists of a mixture of $Al_2O_3$ and mullite, and that the glass material is present in an amount equal to at least 17% by weight of the mixture.

4. Method as claimed in claims 1 and 2, characterized in that the particulate ceramic material substantially consists of $Al_2O_3$, and that the glass material is present in an amount equal to at least 17% by weight of the mixture.

**Revendications**

1. Procédé pour préparer un substrat céramique comportant une surface glacée, à base d'un mélange d'un corps en verre et d'un matériau céramique qui ne réagit pas avec le verre, caractérisé par les étapes de procédé suivantes:

— Préparation d'un mélange céramique intime à base d'un matériau céramique dont les particules ont un diamètre moyen compris dans une fourchette de 0,2 à 35 µm, et d'un corps en verre qui ne réagit pas en contact avec ledit matériau céramique lors de la cuisson de ce matériau à des températures assez élevées pour le fritter, ledit corps en verre ayant un point de ramollissement dans une plage de températures allant de 500 à 1000° C, et étant introduit dans une quantité telle que son volume à l'état fondu soit plus important que les cavités formées dans ledit matériau céramique du fait du frittage.
— Réalisation dudit mélange céramique.
— Application de l'objet en céramique cru obtenu sur un moule constitué par un matériau qui ne peut pas être mouillé par un corps en verre à l'état fondu.
— Cuisson dudit objet appliqué sur ledit moule dans une atmosphère qui ne réagit pas avec ledit corps en verre fondu, afin de fritter ledit matériau céramique et d'obtenir sur la face dudit substrat en contact avec ledit moule une surface glacée dont la configuration correspond à celle dudit moule.

2. Procédé selon la revendication 1, caractérisé en ce que le substrat céramique fritté est ensuite placé sur un moule présentant une image en relief de la configuration de surface souhaitée de la métallisation à réfléchir sur ledit substrat céramique, que ledit substrat céramique et ledit moule sont chauffés à une température suffisamment supérieure au point de ramollissement du corps en verre pour former sur ledit substrat céramique une configuration de lignes de métallisation en relief sur le corps en verre disposé sur ledit substrat céramique, et que lesdites lignes sont remplies d'un matériau conducteur d'électricité.

3. Procédé selon les revendications 1 et 2, caractérisé en ce que ledit matériau céramique est constitué par un mélange contenant $Al_2O_3$ et de la mullite, et que la quantité du corps en verre équivaut à au moins 17% du mélange du substrat céramique.

4. Procédé selon les revendications 1 et 2, caractérisé en ce que ledit matériau céramique est essentiellement constitué par du $Al_2O_3$, et que la quantité du corps en verre équivaut à au moins 17% du mélange du substrat céramique.